# EUROPEAN PATENT APPLICATION

(11) **EP 4 333 303 A1**
(43) Date of publication of application: **06.03.2024**
(21) Application number: 22192731.2
(22) Date of filing: 30.08.2022
(51) Int. Cl.: H03K 17/12, H03K 17/14, H02M 1/088

(54) **TEMPERATURE-BASED VARIABLE CURRENT CONTROL FOR POWER MODULES**

(71) Applicant: Siemens Aktiengesellschaft, 80333 München (DE)
(72) Inventor: Robinson, Jonathan, 90489 Nürnberg (DE)
(74) Representative: Siemens Patent Attorneys

(57) **Abstract**

The application discloses a controller for a power module having at least two half-bridges. The controller comprises logic circuitry, which is configured to determine a power module control signal based on a current to be provided by the power module and to receive a current signal for each one of the at least two half-bridges, each current signal being indicative of a current at the output of the respective half-bridge. The controller is further configured, for at least one of the at least two half-bridges, to receive a respective temperature signal, each temperature signal being indicative of a temperature of the respective half-bridge, and to determine a respective half-bridge control signal, each half-bridge control signal being configured to control the respective half-bridge and being based on the power module control signal, the respective temperature signal and the respective current signal.

## Description

### TECHNICAL FIELD

The invention generally relates to controlling power modules and more precisely to improving the robustness of power modules.

### BACKGROUND

Power modules typically include switches arranged as half-bridges. During operation of the power modules, the various half-bridges heat up to an average operating temperature, which may e.g., be 100°, and further experience temperature variations, which may be in the range of ambient temperature, e.g. 20°, to the maximum junction temperature, e.g. 150°. Both a high average operating temperature as well as temperature variations lead to performance and reliability degradations of a power module. At the same time, while reducing the current output of a power module may reduce the average operating temperature of the power module, this is typically not an option since the power module needs to provide the current required by the load coupled to the power module.

Therefore, it is an objective of the present invention to increase the robustness of a power module while maintain the total current output at the required level.

### SUMMARY OF THE INVENTION

To achieve this objective, the present invention provides a controller for a power module having at least two half-bridges, comprising logic circuitry configured to determine a power module control signal based on a current to be provided by the power module, receive a current signal for each one of the at least two half-bridges, each current signal being indicative of a current at the output of the respective half-bridge, and for at least one of the at least two half-bridges receive a respective temperature signal, each temperature signal being indicative of a temperature of the respective half-bridge, , and determine a respective half-bridge control signal, each half-bridge control signal being configured to control the respective half-bridge and being based on the power module control signal, the respective temperature signal and the respective current signal.

Further, the present invention provides a method for controlling a power module having at least two half-bridges, comprising the steps of: determining a power module control signal to be provided to a power module, receiving a respective current signal for each one of the at least two half-bridges, each current signal being indicative of a current at the output of the respective half-bridge, and for at least one of the at least two half-bridges receiving a respective temperature signal, each temperature signal being indicative of a temperature of the respective half-bridge, receiving a respective current signal, each current signal being indicative of a current at the output of the respective half-bridge, and determining a respective half bridge control signal, each half-bridge control signal being configured to control the respective half-bridge and being based on the power module control signal, the respective temperature signal and the respective current signal.

### BRIEF DESCRIPTION OF THE DRAWINGS

Embodiments of the present invention will be described with reference to the following appended drawings, in which like reference signs refer to like elements.
FIG. 1 schematically illustrates a power system according to embodiments of the present invention.
FIG. 2 schematically illustrates a controller for a power module according to embodiments of the present invention.
FIG. 3 schematically provides a more detailed illustration of the controller for a power module of Fig. 2 according to embodiments of the present invention.
FIGS. 4a and 4b schematically illustrate a current output and temperature measurements of a power module according to embodiments of the present invention.
Fig. 5 provides a flow-chart of a method for controlling a power module according to embodiments of the present invention.

It should be understood that the above-identified drawings are in no way meant to limit the disclosure of the present invention. Rather, these drawings are provided to assist in understanding the invention. The person skilled in the art will readily understand that aspects of the present invention shown in one drawing may be combined with aspects in another drawing or may be omitted without departing from the scope of the present invention.

### DETAILED DESCRIPTION

The invention generally provides a controller for a power module and a corresponding control method. The controller determines for each half-bridge in the power module a respective half-bridge control signal. The determination of the half-bridge control signals is based on the temperature and the current output of each half-bridge as well as on the current to be output by the power module. The output of each half-bridge contributes to the current output of the power module and is determined by the half-bridge control signals. To increase the robustness of the power module, the controller determines individual half-bridge control signals based on the temperature of the respective half-bridge. This leads to different current outputs of the half-bridges if required due to temperature variations inside the module. At the same time, the controller takes into account the current to be output by the module and thus maintains that the sum of the currents output by the half-bridges corresponds to the power to be output by the power module. In other words, the controller varies the current output by the half-bridges based on the respective half-bridge control signals to reduce the temperature of the half-bridges and thereby increase robustness while ensuring that the total current output of the power remains the same.

This general concept will now be explained by describing various detailed control schemes implementing the above concept.

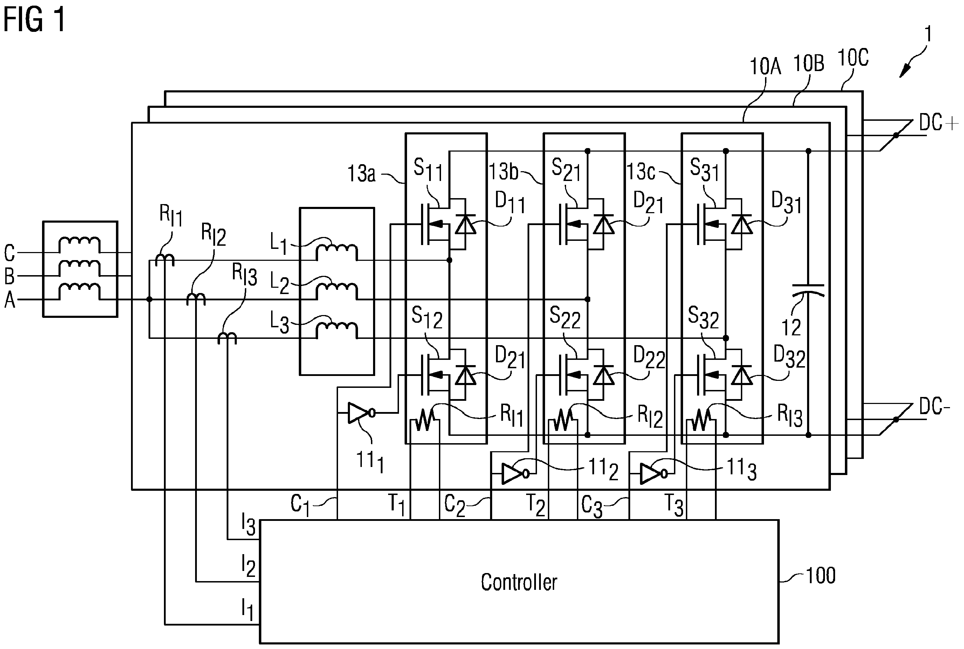

FIG. 1 shows a power system 1 including three power modules 10A, 10B and 10C, a load 20 and a controller 100. In the example of power system 1, the three power modules 10A, 10B and 10C are identical. For simplicity, only power module 10A is thus shown in detail and discussed in the following.

Power module 10A of Fig. 1 includes three half-bridges 13a, 13b, and 13c, which each include two switches, respectively labelled in Fig. 1 as switches S₁₁ to S₃₂, and corresponding freewheeling diodes D₁₁ to D₃₂, respectively labelled in Fig. 1 as freewheeling diodes D₁₁ to D₃₂. The switches may be any type of switch suitable to conduct a high current in an enabled state, e.g., 10A or 50A, and to be coupled to voltages of more than 100V or more than 1000V. For example, the switches may be insulated gate bipolar transistors (IGBTs), silicon carbide metal-oxide-semiconductor field effect transistors (SiC-MOSFETs) or gallium nitride high electron mobility transistors (GaN GEMTs). Depending on the type of switch used, the freewheeling diodes may be integrated into the switches or may be external to the switches. For example, if the switches are reverse conducting IGBTs, or SiC-MOSFETs with diode regions, separate freewheeling diodes may be omitted. The drains or collectors, respectively, of the respective high side switches of the three half-bridges 13a, 13b, and 13c are couplable to a power supply terminal, such as DC+. The sources or emitters, respectively, of the respective low side switches of the three half-bridges 13a, 13b, and 13c are couplable to a power supply terminal, such as DC-. The output of each half-bridge is coupled to a corresponding inductance L₁ to L₃ in order to generate a current at the output of each one of the three half-bridges 13a, 13b, and 13c. Inductances L₁ to L₃ may either be part of power module 10A or may be located external to power module 10A, e.g., on a PCB. As shown in Fig. 1, power module 10A may include three half bridges. However, the number of half-bridges shown in Fig. 1 is merely meant as an example. As will be discussed in the following and as alluded to above, the present application determines control signals to vary currents between half-bridges while maintaining that the sum of the currents corresponds to the current to be provided by the module. Accordingly, the controller of the present invention may control power modules with at least two half-bridges.

As shown in Fig. 1, the output of the three half-bridges 13a, 13b, and 13c of power module 10A may be coupled to one phase of the three phases of load 20. The half-bridges of power modules 10B and 10C may be coupled to the other two of the three phases of load 20. Accordingly. Fig. 1 shows interleaved converters. Power modules 10A, 10B and 10C may thus also be referred to as interleaved converters and half-bridges 13a, 13b and 13c may be referred to as interleaved half-bridges. It should be noted, however, that the present application may be employed to control a power module in any kind of power system and is not limited to power modules in an interleaved converter setup. It will therefore also be understood that load 20 being a three-phase load, such as an electric motor, is merely an example. Load 20 may also be a single-phase load or any other load typically coupled to a power module.

Power module 10A may further include a DC link capacitor 12. DC link capacitor 12 may stabilize the voltage supplied by voltage supply terminals DC+ and DC- to power module 10A.

Power module 10A further includes current measurement devices R_{I1}, R_{I2}, and R_{I3} configured to provide current signals I₁, I₂ and I₃ indicative of the current at the outputs of the half-bridges 13a, 13b and 13c. Current measurement devices R_{I1}, R_{I2}, and R_{I3} may e.g., be measurement resistors measuring the current at the outputs of the half-bridges 13a, 13b and 13c. In general, current measurement devices R_{I1}, R_{I2}, R_{I3} may be any kind of measurement device capable of providing a current signal, i.e., a signal indicative of the current at the outputs of the half-bridges 13a, 13b and 13c.

Similarly, power module 10A further includes temperature measurement devices R_{T1}, R_{T2}, R_{T3} configured to provide signals T₁, T₂ and T₃ to provide a temperature signal, i.e. a signal indicative of the temperature of the half-bridges 13a, 13b and 13c. Temperature measurement devices R_{T1}, R_{T2}, and R_{T3} may e.g. be a thermistor. In general, temperature measurement devices R_{T1}, R_{T2}, R_{T3} may be any kind of temperature measurement device capable of providing a temperature signal, i.e., a signal indicative of the temperature of the half-bridges 13a, 13b and 13c. Temperature measurement devices R_{T1}, R_{T2}, and R_{T3} may e.g., be coupled to the base plate of half-bridges 13a, 13b and 13c. Temperature measurement devices R_{T1}, R_{T2}, R_{T3} may for example also be coupled to a die of one of the switches of half-bridges 13a, 13b and 13c. In some embodiments, there may be two measurement devices per half-bridge, each coupled to the die of each of the switches of the respective half-bridge. In such embodiments, power module 10A may provide two temperature signal per half-bridge. In some embodiments, power module 10A may only include a single temperature measurement device providing a signal indicative of a power module operating temperature. In such embodiments, controller 100 may be configured to determine, based on a physics module of power module 10A, temperature signals indicative of the temperatures of the individual half-bridges 13A, 1b and 13c based on the power module operating temperature. More generally, power module 10A may include at least one temperature measurement device and may include more if desirable for the actual implementation of the present invention.

Controller 100 may be coupled to power module 10A and may receive current signals I₁, I₂ and I₃. Controller 100 may further receive at least one of temperature signals T₁, T₂ and T₃. In addition, controller 100 is coupled to power module 10A to provide half-bridge control signals C₁, C₂ and C₃ to half-bridge 13a, 13b and 13c, respectively. To provide half-bridge control signals C₁, C₂ and C₃, controller 100 includes logic circuitry. The logic circuitry may for example be a microprocessor, an application specific integrated circuit (ASIC), a field programmable gate array (FPGA), or a central processing unit (CPU) of a general-purpose computer. In general, the logic circuitry or controller 100, respectively, may be any kind of circuitry configured to determine control signals C₁, C₂ and C₃ as will be discussed in the following.

Controller 100 is shown in Fig. 1 as a separate entity directly coupled to the gate terminals of switches S₁₁, S₂₁ and S₃₁ and via inverters 11₁, 11₂ and 11₃ to the gate terminals of S₁₂, S₂₂ and S₃₂. However, it should be noted that controller 100 may also be integrated with power module 10A, may be integrated with one or more gate drivers driving switches S₁₁ to S₃₂ or may control gate drivers which in turn control the gate terminals of switches S₁₁ to S₃₂. Further, controller 100 may also be coupled to power modules 10B and 10C in the same manner as controller 100 is coupled to power module 10A. Accordingly, controller 100 may be a global controller for all power modules in power system 1. With regard to power modules 10B and 10C, controller 100 may, as in the case of power module 10A, be also integrated with one or more gate drivers driving the switches of the respective power module or may control gate drivers which in turn control the gate terminals of the switches of the respective power module.

It should be noted that, while the control signals of switches S₁₂, S₂₂ and S₃₂ are shown in Fig. 1 as being directly derived from control signals C₁, C₂ and C₃ via inverters 11₁, 11₂ and 11₃, these signals may also be derived from control signals C₁, C₂ and C₃ in other ways, e.g. by inserting dead times or any other way of avoiding half-bridge shoot-through.

In addition to receiving the above-discussed current signals I₁, I₂ and I₃ as well as temperature signals T₁, T₂ and T₃, the control logic is configured to determine a power module control signal C_{module} based on a current to be provided by power module 10A to load 20. For example, the controller 100 may receive or be provided with information on the current requirements of load 20 and may determine power module control signal C_{module} to control power module 10 to provide the current required by load 20. Based on power module control signal C_{module}, the temperature signals T₁, T₂, and T₃ and the respective current signals I₁, I₂, and I₃, controller 100 determines half-bridge control signals C₁, C₂, and C₃. Half-bridge control signals C₁, C₂, and C₃ then control either directly, as shown in Fig. 1, or indirectly, as discussed above, half-bridges 13a, 13b and 13c to provide the current required by load 20.

More precisely, the half-bridge control signals C₁, C₂, and C₃ cause the corresponding half-bridge 13a, 13b, and 13c to provide respective half-bridge currents. Since the half-bridge control signals C₁, C₂, and C₃ are determined based on power module control signal C_{module} the sum of the half-bridge currents is equal to the current to be provided by power module 10A.

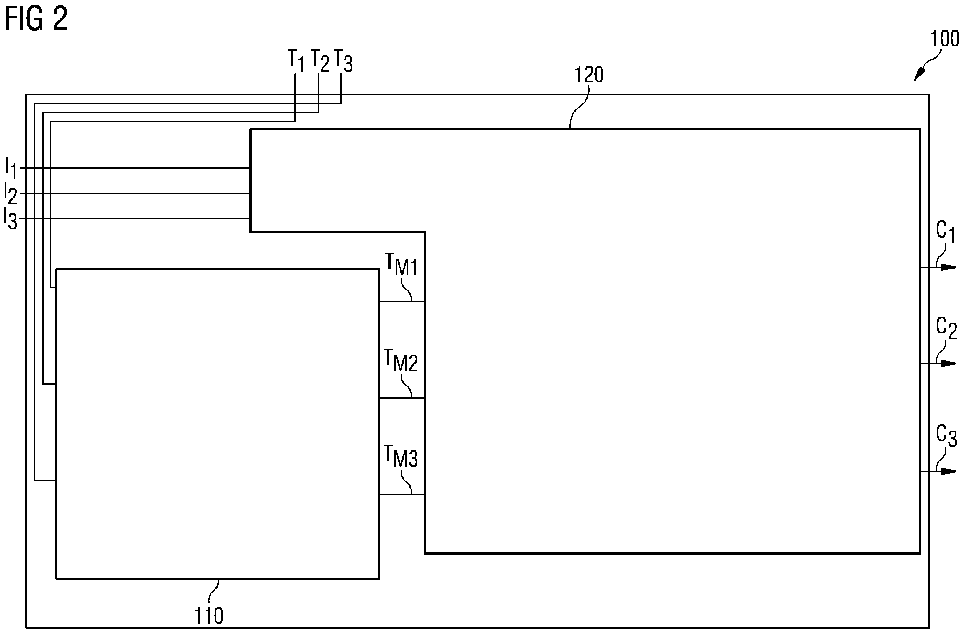

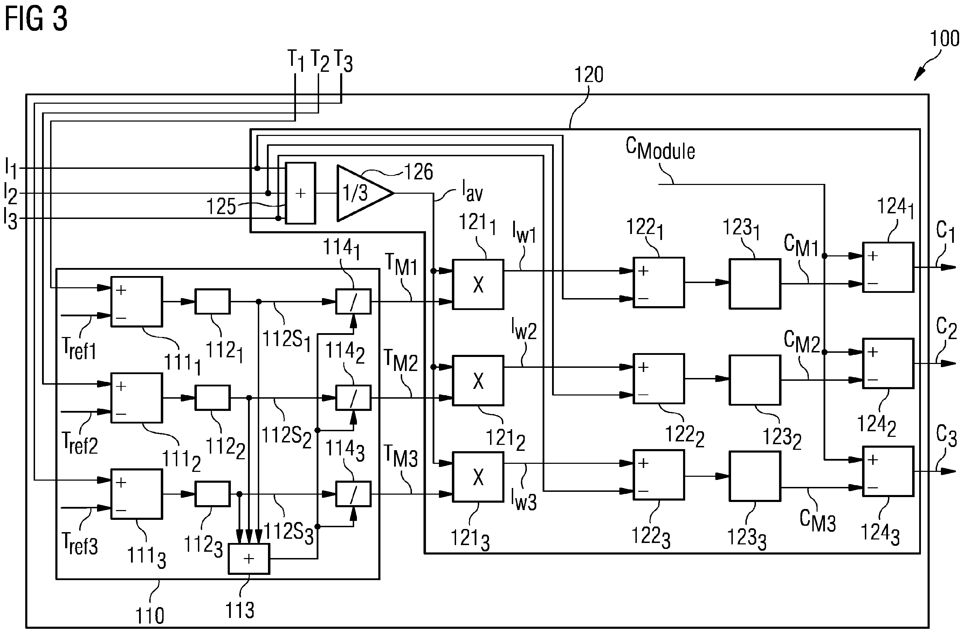

In the following, further details on how controller 100 may determine half-bridge control signals C₁, C₂, and C₃ will be discussed with regard to Figs. 2 and 3.

Fig. 2 illustrates various signals and logic blocks which controller 100 may use to determine half-bridge control signals C₁, C₂, and C₃ based on the inputs and outputs of controller 100 discussed with regard to Fig. 1. Accordingly, controller 100 may include a temperature modification signal determination 110 and a current control modification signal determination 120.

Temperature modification signal determination 110 may receive temperature signals T₁, T₂, and T₃. Further, temperature modification signal determination 110 may receive or determine temperature reference signals T_{ref1}, T_{ref2} and T_{ref3}.

For example, controller 100 may be able to identify power module 10A and thereby switches S₁₁ to S₃₂. Based on the identification, temperature modification signal determination 110 may determine temperature reference signals T_{ref1}, T_{ref2} and T_{ref3}. In a further example, temperature reference signals T_{ref1}, T_{ref2} and T_{ref3} may be a constant value stored in the control logic of controller 100. In a yet a further example, controller 100 may interface with a logic circuit inside power module 10A (not shown) and may receive temperature reference signals T_{ref1}, T_{ref2} and T_{ref3} from this logic circuit.

Temperature reference signals T_{ref1}, T_{ref2} and T_{ref3} indicate a signal value of temperature signals T₁, T₂, and T₃, which corresponds to a temperature threshold. Above this temperature threshold, the operating temperature of the respective half-bridge 13a, 13b and 13c may lead to a degradation of the performance of the power module.

Based on the temperature signals T₁, T₂ and T₃ and the temperature reference signals T_{ref1}, T_{ref2} and T_{ref3}, temperature modification signal determination 110 may determine temperature modification signals T_{M1}, T_{M2} and T_{M3}.

To determine temperature modification signals T_{M1}, T_{M2} and T_{M3}, temperature modification signal determination 110 may compare temperature signals T₁, T₂, and T₃ with a temperature profile of power module 10A. The temperature profile may for example define a single temperature threshold, i.e., temperature reference signals T_{ref1}, T_{ref2} and T_{ref3}, or various temperature thresholds for the temperatures of half-bridges 13a, 13b, 13c, e.g. depending on the lifetime of power module 10A. Temperature modification signal determination 110 may in some examples also receive current signals I₁, I₂, and I₃ (not shown) and the temperature profile may indicate temperature thresholds based on the current output by half-bridges 13a, 13b and 13c. In such a case, the temperature thresholds indicated by the temperature profile may further depend on the lifetime. In summary, the temperature profile may indicate one or more temperature thresholds per half-bridge. In the latter case, the temperature profile may provide a plurality of temperature thresholds depending on at least one of the lifetime of power module 10A, previously experienced operating temperatures of power module 10A and the current output of the power module 10A.

Controller 100 may determine the temperature profile based on e.g., recording temperature signals T₁, T₂, and T₃ of power module 10A over time, may be provided with the temperature profile as a data set included in controller 100 or may be provided with the temperature profile by another entity, such as control logic of power module 10A.

The temperature profile may further indicate temperature modification signals T_{M1}, T_{M2} and T_{M3} for each of the temperature thresholds included in the temperature profile. Accordingly, temperature modification signal determination 110 may determine the temperature modification signals T_{M1}, T_{M2} and T_{M3} based on the comparison of the temperature signals T₁, T₂, and T₃ with the temperature profile.

In a further example of the present invention, temperature modification signal determination 110 may determine temperature modification signals T_{M1}, T_{M2} and T_{M3} as shown in Fig. 3. Fig. 3 provides a detailed view of an example of temperature modification signal determination 110.

Temperature modification signal determination 110 of Fig. 3 may include temperature difference determinators 111₁, 111₂, 111₃, temperature feedback control functions 112₁, 112₂, and 112₃, temperature feedback control signal summing unit 113 and signal dividers 114₁, 114₂ and 114₃. It will be understood that these entities illustrate logic functions performable by the logic circuitry of controller 100.

Temperature difference determinators 111₁, 111₂, 111₃, may determine a temperature difference between temperature signals T₁, T₂, and T₃ and corresponding temperature reference signals T_{ref1}, T_{ref2} and T_{ref3}. Temperature difference determinators 111₁, 111₂, 111₃ may then provide the temperature differences to temperature feedback control functions 112₁, 112₂, 112₃.

Temperature feedback control functions 112₁, 112₂, and 112₃ may perform a temperature feedback control function on the temperature differences to obtain respective temperature feedback control signals 112S₁, 112S₂, and 112S₃. Temperature feedback control functions 112₁, 112₂, and 112₃ may be any suitable feedback control function enabling determination of temperature modification signals T_{M1}, T_{M2} and T_{M3}. For example, temperature feedback control functions 112₁, 112₂, and 112₃ may be one of a proportional-integral control function or a proportional resonant control function. Temperature feedback control functions 112₁, 112₂, and 112₃ ensure that temperature modification signals T_{M1}, T_{M2} and T_{M3} provide a signal value proportional to the modification in temperature necessary to improve the robustness of power module 10A.

Temperature feedback control signals 112S₁, 112S₂, and 112S₃ are summed up by temperature feedback control signal summing unit 113. The sum generated by temperature feedback control signal summing unit 113 as well as temperature feedback control signals 112S₁, 112S₂, and 112S₃ are then provided to signal dividers 114₁, 114₂ and 114₃. Signal dividers 114₁, 114₂ and 114₃ divide the temperature feedback control signals 112S₁, 112S₂, 112S₃ with the sum generated by temperature feedback control signal summing unit 113 to generate temperature modification signals T_{M1}, T_{M2} and T_{M3}. Dividing the temperature feedback control signals 112S₁, 112S₂, and 112S₃ by their sum ensures that the total current provided by power module 10A corresponds to the current specified by power module control signal C_{module}.

Returning to Fig. 2, based on temperature modification signals T_{M1}, T_{M2}, and T_{M3} determined as discussed above as well as current signals I₁, I₂ and I₃, current control modification signal determination 120 may determine control modification signal C_{M1}, C_{M2}, C_{M3}. Current control modification signal determination 120 may then modify, based on control modification signals C_{M1}, C_{M2} and C_{M3}, power module control signal C_{mod-ule} to obtain half bridge control signal C₁, C₂ and C₃.

To determine control modification signals C_{M1}, C_{M2} and C_{M3}, current control modification signal determination 120 may compare the temperature modification signals T_{M1}, T_{M2}, and T_{M3} with a current look-up table stored or otherwise provided to controller 100 to select a value of each control modification signal C_{M1}, C_{M2}, C_{M3}. In other words, the current look-up table may include one or more values by which to modify the power module control signal. In examples of the present invention, in which the current look-up table includes a single value for each of the control modification signals C_{M1}, C_{M2} and C_{M3}, control modification signals C_{M1}, C_{M2} and C_{M3} may be considered as a temperature-based constant offset of power module control signal C_{module}. In examples of the present invention, in which the current look-up table includes a plurality of values for each of the control modification signals C_{M1}, C_{M2} and C_{M3}, the values of control modification signals C_{M1}, C_{M2} and C_{M3} may, in addition to temperature modification signals T_{M1}, T_{M2}, and T_{M3}, be chosen based on e.g., at least one of a lifetime of power module 10A and previous currents provided by half-bridges 13a, 13b and 13C.

In a further example of the present invention, current control modification signal determination 120 may determine control modification signals C_{M1}, C_{M2} and C_{M3} as shown in Fig. 3. Fig. 3 provides a detailed view of an example of current control modification signal determination 120.

Current control modification signal determination 120 of Fig. 3 may include current signal weighting units 121₁, 121₂ and 121₃, current difference determinators 122₁, 122₂ and 122₃, current feedback control functions 123₁, 123₂, and 123₃ and half-bridge control signal summing units 124₁, 124₂ and 124₃. Current control modification signal determination 120 may further include current signal summing unit 125 and current signal sum divider 126.

Current signal weighting units 121₁, 121₂ and 121₃ may multiply each temperature modification signal T_{M1}, T_{M2}, and T_{M3} with an average half-bridge current Iₐᵥ to generate respective weighted average half-bridge currents I_{w1}, I_{w2}, I_{w3}. Current signal summing unit 125 and current signal sum divider 126 may determine average half-bridge current Iₐᵥ by summing up current signals I₁, I₂ and I₃ and dividing the sum by the number of half-bridges included power module 10A.

By weighting average half-bridge current Iₐᵥ with temperature modification signal T_{M1}, T_{M2}, and T_{M3}, current signal weighting units 121₁, 121₂ and 121₃ ensure that control modification signal C_{M1}, C_{M2} and C_{M3} determined by current control modification signal determination 120 lead to the reduction in temperature necessary to increase the robustness of power module 10A.

Current difference determinators 122₁, 122₂ and 122₃ may determine a current difference between current signals I₁, I₂ and I₃ and the respective weighted average half-bridge currents I_{w1}, I_{w2} and I_{w3}. On each of these current differences, current feedback control functions 123₁, 123₂, and 123₃ may perform feedback control functions to obtain respective control modification signals C_{M1}, C_{M2}, and C_{M3}. The current feedback control functions 123₁, 123₂, and 123₃ may be any one of a proportional-integral control function or a proportional resonant control function. Current feedback control functions 123₁, 123₂, and 123₃ further ensure that control modification signal C_{M1}, C_{M2} and C_{M3} lead to a reduction in current causing the temperature reduction necessary to increase the robustness and thereby the reliability of power module 10A.

Finally, half-bridge control signal summing units 124₁, 124₂ and 124₃ may sum up control modification signal C_{M1}, C_{M2} and C_{M3} and power module control signal C_{module} in order to obtain half-bridge control signals C₁, C₂ and C₃. It will be understood that control modification signal C_{M1}, C_{M2} and C_{M3} may be of negative value and thus summing up control modification signal C_{M1}, C_{M2} and C_{M3} and power module control signal C_{module} may in fact be a subtraction.

In addition to the above, power controller may, in cases in which power module 10A provides more than one temperature signal per half-bridge 3a, 3b and 3c, e.g. two temperature signal per half-bridge, each indicative of a temperature of a die of the respective switch, determine an average half bridge temperature signal used as the respective temperature signal for each half-bridge in order to integrate such signals into the control scheme discussed above.

Controller 100 has been described above as determining half-bridge control signals C₁, C₂ and C₃ equally. However, in some embodiments, only the half-bridge control signal of one of the half-bridges 13a, 13b and 13c may be based on the respective temperature signal T₁, T₂ and T₃. In other words, temperature modification signal determination 110 of controller 100 may determine only one temperature modification signal T_{M1}, T_{M2}, T_{M3} as discussed above. Current control modification signal determination 120 may then determine one half-bridge control modification signal C_{M1}, C_{M2} or C_{M3} based on the corresponding temperature modification signal and may derive the other half-bridge control signals based on the half-bridge control modification signal determined based on the respective temperature signal T₁, T₂ and T₃. Since controller 100 determines half-bridge control modification signal C_{M1}, C_{M2} or C_{M3} by ensuring that the sum of the currents provided by the respective half-bridges corresponds to the current to be provided by the power module, determining only one half-bridge control modification signal based on the respective temperature signal may still enable the determination of half-bridge control signals C₁, C₂ and C₃ which lead to the reduction in temperature necessary to increase the robustness of power module 10A.

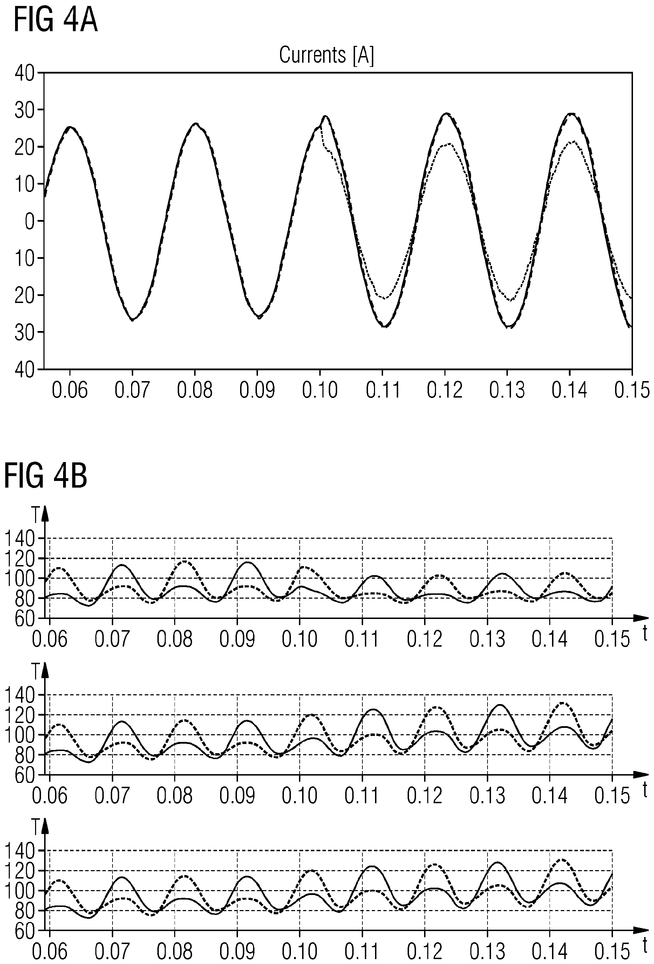

Figs. 4a and 4b schematically illustrate exemplary current signals I₁, I₂ and I₃ of half-bridges 13a, 13b and 13c as well as exemplary temperature signals indicative of the temperature of the individual switches of half-bridges 13a, 13b and 13c. Figs. 4a and 4b. As can be seen in Fig. 4a, current signals I₁, I₂, and I₃ are identical until t = 0.1s. Afterwards, the value of current signal I₁ is reduced compared to the value of current signals I₂ and I₃ due to controller 100 controlling half-bridge 13a using half-bridge control signal C1. This reduction in value of current signal I₁ leads to a corresponding reduction of the temperature of half-bridge 13a, as seen in the first temperature diagram of Fig. 4b. However, the total current output of power module 10A remains the same as current signals I₂ and I₃ indicate that half-bridges 13b and 13c are controlled to compensate the reduced current output of half-bridge 13a.

It should be noted that the temperatures in all three temperature diagrams of Fig. 4b vary due the 50Hz harmonic. The reduction in temperature visible at t = 0.1s reduces the variations of the temperatures of the switches of half-bridge 13a from approximately 40° to 20°. Since the reduction in robustness caused by temperature increases exponentially with increasing temperature, the control signals C₁, C₂ and C₃ lead to a significant improvement in robustness. The same applies even more acutely in cases of a load step (not shown), where controller 100 may be able to reduce the increase in temperature from ambient temperature at e.g. 40° to 100° instead of e.g. 120°.

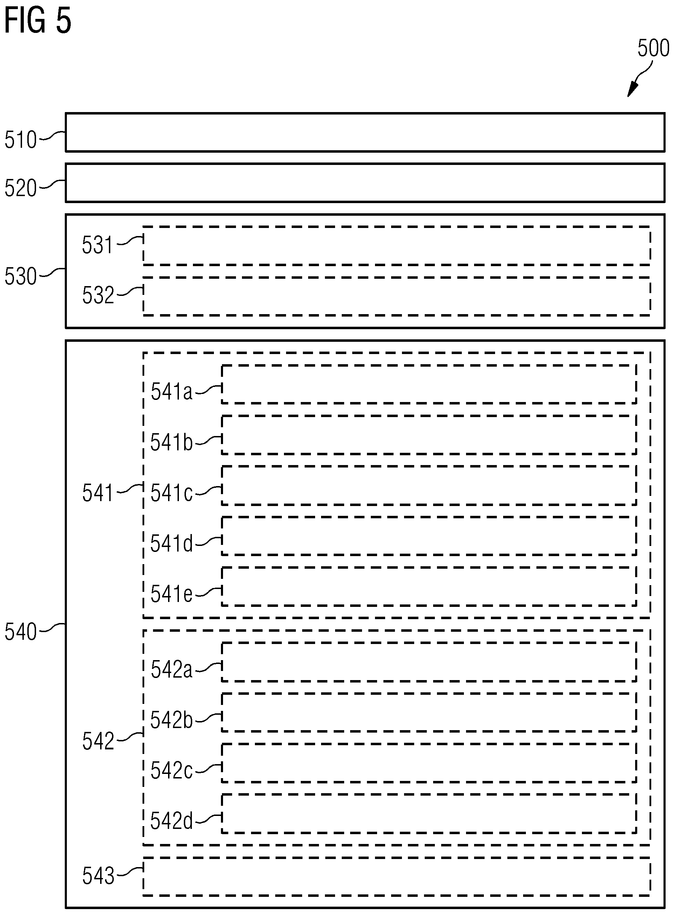

Fig. 5 shows a flowchart of method 500 for controlling a power module. Method 500 may for example be performed by the control logic of controller 100 as discussed above. Optional features of method 500 are shown as dashed boxes. While the method will be described with regard to power module 10A, it will be understood that the method may be used to control any one of power modules 10A, 10B and 10C either alone or together. To avoid repetitions, the discussion of method 500 will not repeat any of the definitions or explanations
already provided above with regard to power controller 100. In step 510, method 500 determines power module control signal C_{module} based on a current to be provided by power module 10A

In Step 520, method 500 receives current signals I₁, I₂ and I₃ for each one of the at least two half-bridges 13a, 13b, and 13c. As discussed above, current signals I₁, I₂ and I₃ are indicative of a current at the output of the respective half-bridge.

In step 530, method 500 receives respective temperature signals T₁, T₂, and T₃. As discussed above, temperature signals T₁, T₂, and T₃ are indicative of the temperature of the respective half-bridge 13a, 13b and 13c.

Step 530 may include a step 531, in which method 500 may receive two temperature signals for at least one half-bridge. Each of these two temperature signals is indicative of a temperature of a die of each switch of the half-bridge. Further, step 530 may include a step 532, in which method 500 may determine an average half bridge temperature signal used as the respective temperature signal for the half-bridge.

In step 540, method 500 determines the respective half-bridge control signal C₁, C₂ and C₃. Each half-bridge control signal is configured to control the respective half-bridge 13a, 13b and 13c and is based on the power module control signal C_{mod-ule}, the respective temperature signal and the respective current signal.

Step 540 may include a step 541, in which method 500 may determine temperature modification signals T_{M1}, T_{M2} and T_{M3} based on respective temperature signals T₁, T₂, T₃ and corresponding temperature reference signal T_{ref1}, T_{ref2}, and T_{ref3}. To determine temperature modification signals T_{M1}, T_{M2} and T_{M3}, step 541 may in some examples of the present invention include steps 541a and 541b. In Step 541a, method 500 may compare temperature signals T₁, T₂, and T₃ with the temperature profile of power module 10A discussed above. In step 541b, method 500 may determine temperature modification signals T_{M1}, T_{M2}, T_{M3} based on the comparison. In some examples of the present invention, step 541 may include steps 541c, 541d and 541e to determine temperature modification signals T_{M1}, T_{M2} and T_{M3}. In step 541c, method 500 may determine a temperature difference between temperature signals T₁, T₂ and T₃ and the respective corresponding temperature reference signal T_{ref1}, T_{ref2}, T_{ref3}. In step 541d, method 500 may perform temperature feedback control functions 112₁, 112₂, 112₃ on the temperature differences to obtain respective temperature feedback control signals 112S₁, 112S₂, 112S₃. In step 541e, method 500 may divide temperature feedback control signals 112S₁, 112S₂, 112S₃ with a sum of all feedback control signals.

Step 540 may further include step 542, in which method 500 may determine control modification signals C_{M1}, C_{M2} and C_{M3} based on the respective temperature modification signals T_{M1}, T_{M2} and T_{M3} and the respective current signals I₁, I₂ and I₃. To determine control modification signals C_{M1}, C_{M2} and C_{M3}, method 500 may include step 542a. In step 542a, method 500 may compare temperature modification signals T_{M1}, T_{M2} and T_{M3} with the current look-up table discussed above to select a value of control modification signals C_{M1}, C_{M2} and C_{M3}. The current look-up table may include one or more values by which to modify the power module control signal C_{module}. In some examples of the present invention, step 542 may include steps 542b, 542c and 542d to determine control modification signals C_{M1}, C_{M2} and C_{M3}. In step 542b, method 500 may multiply temperature modification signals T_{M1}, T_{M2}, and T_{M3} with an average half-bridge current Iₐᵥ to generate weighted average half-bridge currents I_{w1}, I_{w2}, and I_{w3}. To determine the average half-bridge current Iₐᵥ, method 500 may divide the sum of current signals I₁, I₂ and I₃ by the number of half-bridges included in power module 10a. In step 542c, method 500 may determine current differences between each current signal I₁, I₂ and I₃ and each respective weighted average half-bridge current I_{w1}, I_{w2} and I_{w3}. In step 542d, method 500 may perform current feedback control functions 123₁, 123₂ and 123₃ on the current differences to obtain respective control modification signal C_{M1}, C_{M2} and C_{M3}.

Step 540 may finally include step 543, in which method 500 may modify the power module control signal C_{module} based on control modification signals C_{M1}, C_{M2} and C_{M3} to obtain half bridge control signals C₁, C₂ and C₃.

It should be noted that method 500 may determine a temperature modification signal as discussed above for only one half-bridge. In such examples of the present invention, method 500 may perform steps 530 and 540 as discussed above for one half-bridge. With regard to the other half-bridges, step 530 may be skipped and method 500 may determine the current control modification signals of the other half-bridges based on the power module control signal C_{module}, the half-bridge control signal determined based on the respective temperature signal and the respective current signal. In other words, the temperature control of the other half-bridges is performed based on the temperature control of one half-bridge. This is enabled due to the fact that a change of the value of the directly temperature-controlled half-bridge control signal affects the half-bridge control signals of the other half-bridges since method 500 ensures that the total current provided by the power module still corresponds to the current to be provided according to power module control signal C_{module}. In such examples of method 500, the other half-bridges are accordingly indirectly temperature-controlled.

Depending on the actual implementation of method 500, method 500 may perform steps 530 and 540 also for more than one half-bridge of power modules 10A, 10B and 10C.

The preceding description has been provided to illustrate how to determine control signals for half-bridges of a power module taking temperature measurements of the power module into account. It should be understood that the description is in no way meant to limit the scope of the invention to the precise embodiments discussed throughout the description. Rather, the person skilled in the art will be aware that these embodiments may be combined, modified or condensed without departing from the scope of the invention as defined by the following claims.

## Claims

1. A controller (100) for a power module (10A, 10B, 10C) having at least two half-bridges (13a, 13b, 13c), comprising logic circuitry configured to:
determine a power module control signal (C_{module}) based on a current to be provided by the power module (10A, 10B, 10C);
receive a current signal (I₁, I₂, I₃) for each one of the at least two half-bridges (13a, 13b, 13c), each current signal being indicative of a current at the output of the respective half-bridge (13a, 13b, 13c); and for at least one of the at least two half-bridges (13a, 13b, 13c):
receive a respective temperature signal (T₁, T₂, T₃), each temperature signal being indicative of a temperature of the respective half-bridge (13a, 13b, 13c); and
determine a respective half-bridge control signal (C₁, C₂, C₃), each half-bridge control signal being configured to control the respective half-bridge (13a, 13b, 13c) and being based on the power module control signal (C_{module}), the respective temperature signal (T₁, T₂, T₃) and the respective current signal (I₁, I₂, I₃).

2. The controller (100) of claim 1, wherein:
each half-bridge control signal (C₁, C₂, C₃) causes the corresponding half-bridge (13a, 13b, 13c) to provide a respective half-bridge current, and
the sum of all half-bridge currents is equal to the current to be provided by the power module (10A, 10B, 10C).

3. The controller (100) of any one of claims 1 or 2, wherein, to determine each respective half-bridge control signal (C₁, C₂, C₃), the logic circuitry is further configured to:
determine a respective temperature modification signal (T_{M1}, T_{M2}, T_{M3}) based on the respective temperature signal (T₁, T₂, T₃) and a respective corresponding temperature reference signal (T_{ref1}, T_{ref2}, T_{ref3}) ;
determine a respective control modification signal (C_{M1}, C_{M2}, C_{M3}) based on the respective temperature modification signal (T_{M1}, T_{M2}, T_{M3}) and the respective current signal (I₁, I₂, I₃); and
modify the power module control signal (C_{module}) based on the respective control modification signal (C_{M1}, C_{M2}, C_{M3}) to obtain the respective half bridge control signal (C₁, C₂, C₃).

4. The controller (100) of claim 3, wherein, to determine each temperature modification signal (T_{M1}, T_{M2}, T_{M3}), the logic circuitry is further configured to:
compare each temperature signal (T₁, T₂, T₃) with a temperature profile of the power module (10A, 10B, 10C);
determine each temperature modification signal (T_{M1}, T_{M2}, T_{M3}) based on the comparison.

5. The controller of claim 3, wherein, to determine each temperature modification signal (T_{M1}, T_{M2}, T_{M3}), the logic circuitry is further configured to:
determine a temperature difference between each temperature signal (T₁, T₂, T₃) and the respective corresponding temperature reference signal (T_{ref1}, T_{ref2}, T_{ref3}) ;
perform a temperature feedback control function (112₁, 112₂, 112₃) on each temperature difference to obtain a respective temperature feedback control signal (112S₁, 112S₂, 112S₃); and
divide each temperature feedback control signal (112S₁, 112S₂, 112S₃) with a sum of all feedback control signals.

6. The controller (100) of any one of claims 3 to 5, wherein, to determine each control modification signal (C_{M1}, C_{M2}, C_{M3}), the logic circuitry is further configured to:
compare each temperature modification signal (T_{M1}, T_{M2}, T_{M3}) with a current look-up table to select a value of each control modification signal, the current look-up table including one or more values by which to modify the power module control signal (C_{module}) .

7. The controller of any one of claims 3 to 5, wherein, to determine each control modification signal (C_{M1}, C_{M2}, C_{M3}), the logic circuitry is further configured to:
multiply each temperature modification signal (T_{M1}, T_{M2}, T_{M3}) with an average half-bridge current (Iₐᵥ) to generate a respective weighted average half-bridge current (I_{w1}, I_{w2}, Iw3) ;
determine a current difference between each current signal (I₁, I₂, I₃) and each respective weighted average half-bridge current (I_{w1}, I_{w2}, I_{w3});
perform a current feedback control function (123₁, 123₂, 123₃) on each current difference to obtain the respective control modification signal (C_{M1}, C_{M2}, C_{M3}).

8. The controller (100) of claim 7, wherein the logic circuitry is configured to determine the average half-bridge current (Iₐᵥ) based on a sum of all current signals (I₁, I₂, I₃) divided by the number of half-bridges (13a, 13b, 13c) included in the power module (10a, 10b, 10c).

9. The controller (100) of any one of claims 5 to 8, wherein the temperature feedback control function (112₁, 112₂, 112₃) and the current feedback control function (123₁, 123₂, 123₃) are each respectively any one of a proportional-integral control function or a proportional resonant control function.

10. The controller of any one of the preceding claims, wherein the logic circuitry is further configured to:
receive two temperature signals for the at least one half-bridge (13a, 13b, 13c), each temperature signal being indicative of a temperature of a die of each switch (S₁₁ - S₃₂) of the half-bridge (13a, 13b, 13c); and
determine an average half bridge temperature signal used as the respective temperature signal for the half-bridge (13a, 13b, 13c).

11. The controller (100) of any one of the preceding claims, wherein the logic circuitry is further configured to:
receive the respective temperature signal (T₁, T₂, T₃) and determine the respective half-bridge control signal (C₁, C₂, C₃) based on the power module control signal (C_{module}) , the respective temperature signal (T₁, T₂, T₃) and the respective current signal (I₁, I₂, I₃) for only one of the at least two half-bridges (13a, 13b, 13c); and
determine the respective half-bridge control signal (C₁, C₂, C₃) of the at least other one of the at least two half-bridges (13a, 13b, 13c) based on the power module control signal (C_{module}), the half-bridge control signal (C₁, C₂, C₃) determined based on the respective temperature signal (T₁, T₂, T₃), and the respective current signal (I₁, I₂, I₃).

12. A method (500) for controlling a power module (10A, 10B, 10C) having at least two half-bridges (13a, 13b, 13c), comprising the steps of:
determining (510) a power module control signal (C_{module}) to be provided to a power module (10A, 10B, 10C);
receiving a respective current signal (I₁, I₂, I₃) for each one of the at least two half-bridges (13a, 13b, 13c), each current signal being indicative of a current at the output of the respective half-bridge (13a, 13b, 13c); and
for at least one of the at least two half-bridges (13a, 13b, 13c):
receiving a respective temperature signal (T₁, T₂, T₃), each temperature signal being indicative of a temperature of the respective half-bridge (13a, 13b, 13c); and
determining a respective half bridge control signal (C₁, C₂, C₃), each half-bridge control signal being configured to control the respective half-bridge (13a, 13b, 13c) and being based on the power module control signal (C_{module}) , the respective temperature signal (T₁, T₂, T₃) and the respective current signal (I₁, I₂, I₃).

13. The method (500) of claim 12, wherein:
the power module control signal (C_{module}) is determined based on a current to be provided by the power module (10A, 10B, 10C),
each half-bridge control signal (C₁, C₂, C₃) causes the corresponding half-bridge (13a, 13b, 13c) to provide a respective half-bridge current, and
the sum of all half-bridge currents is equal to the current to be provided by the power module (10A, 10B, 10C).

14. The method (500) of any one of claims 12 to 13, wherein determining each respective half-bridge control signal (C₁, C₂, C₃) comprises:
determining a respective temperature modification signal (T_{M1}, T_{M2}, T_{M3}) based on the respective temperature signal (T₁, T₂, T₃) and a respective corresponding temperature reference signal (T_{ref1}, T_{ref2}, T_{ref3}) ;
determining a respective control modification signal (C_{M1}, C_{M2}, C_{M3}) based on the respective temperature modification signal (T_{M1}, T_{M2}, T_{M3}) and the respective current signal (I₁, I₂, I₃); and
modifying the power module control signal based on the respective control modification signal (C_{M1}, C_{M2}, C_{M3}) to obtain the respective half bridge control signal (C₁, C₂, C₃).

15. The method (500) of any one of claims 12 to 14, wherein:
The steps of receiving the respective temperature signal (T₁, T₂, T₃) and determining the respective half-bridge control signal (C₁, C₂, C₃) based on the power module control signal (C_{module}) , the respective temperature signal (T₁, T₂, T₃) and the respective current signal (I₁, I₂, I₃) are performed for only one of the at least two half-bridges (13a, 13b, 13c); and
the step of determining the respective half-bridge control signal (C₁, C₂, C₃) of the at least other one of the at least two half-bridges (13a, 13b, 13c) is based on the power module control signal (C_{module}), the half-bridge control signal (C₁, C₂, C₃) determined based on the respective temperature signal (T₁, T₂, T₃), and the respective current signal (I₁, I₂, I₃).
